# EUROPÄISCHE PATENTSCHRIFT

(11) **EP 0 570 402 B1**
(45) Veröffentlichungstag und Bekanntmachung des Hinweises auf die Patenterteilung: **09.07.1997**
(21) Anmeldenummer: 92903547.5
(22) Anmeldetag: 01.02.1992
(51) Int. Cl.: H03K 9/08

(54) **VERFAHREN UND VORRICHTUNG ZUR ZEIT/SPANNUNGS-WANDLUNG**
PROCESS AND DEVICE FOR TIME/VOLTAGE CONVERSION
PROCEDE ET DISPOSITIF DE CONVERSION TEMPS/TENSION

(30) Priorität: 08.02.1991 DE 4103813
(43) Veröffentlichungstag der Anmeldung: 24.11.1993
(73) Patentinhaber: DEUTSCHE THOMSON-BRANDT GMBH, 78048 Villingen-Schwenningen (DE)
(72) Erfinder: MAIER, Michael, D-7605 Bad Peterstal-Griesbach (DE); BENOIT, Eric, W-7750 Schwenningen (DE)
(86) Internationale Anmeldenummer: EP9200219
(87) Internationale Veröffentlichungsnummer: WO9214303

(56) Entgegenhaltungen:
- EP-A- 0 417 578
- GB-A- 1 397 411
- US-A- 4 716 398
- NTIS TECH NOTES. Nr. 3B, März 1986, SPRINGFIELD, VA US Seite 282; G. SOSACK ET AL.: 'Pulse-Width-to-Analog-Voltage Converter'
- PATENT ABSTRACTS OF JAPAN, Bd. 6, Nr. 119 (E-116)(997) 3. Juli 1982;& JP-A-57048826
- PATENT ABSTRACTS OF JAPAN, Bd. 15, Nr. 20 (P-1154)17. Januar 1991;& JP-A-2264295

## Beschreibung

Die Erfindung betrifft ein Verfahren zur Umwandlung von Zeitwerten, die der Dauer eines Impulses entsprechen, in Spannungswerte, sowie eine Vorrichtung zur Durchführung des erfindungsgemäßen Verfahrens.

Aus der älteren Anmeldung EP-A 0 417 578 (Stand der Technik nach Art. 54(1)(3) EPÜ), die eine Ansteuerschaltung für eine Flüssigkristallanzeige vorstellt, ist ein Stromverstärker bekannt, der eine Kombination darstellt aus einem Spannungs/Zeit-Wandler und einem Zeit/Spannungs-Wandler. Dabei wandelt der Spannungs/Zeit-Wandler ein Videoeingangssignal in ein pulsbreitenmoduliertes Signal mit Impulsen unterschiedlicher, von der Höhe der Video eingangs spannung abhängiger, Dauer um.

Dieses pulsbreitenmodulierte Signal wird anschließend durch den Zeit/Spannungs-Wandler in einen Spannungswert gewandelt, der von der Dauer des jeweiligen Impulses abhängig ist.

Eine mögliche Realisierung des dort vorgestellten Zeit/Spannungs-Wandlers- enthält einen MOS-Transistor, dessen Gate das pulsbreitenmodulierte Signal zugeführt wird. An der Source-Elektrode des MOS-Transistors liegt eine Spannung an, die von einem Maximalwert mit einer konstanten Steigung auf Null Volt abfällt. Ein an der Drain-Elektrode angeschlossener Kondensator wird dadurch mittels einer Rampenspannung geladen. An dem Kondensator ist eine jeweilige Spannung abgreifbar.

Der aus der genannten Anmeldung bekannte Spannungs/Zeit-Wandler, liefert Impulse, deren Dauer unterschiedlich Lang ist, deren Spannungsverlauf während der jeweiligen Impulsdauer jedoch im Wesentlichen konstant ist. Es hat sich herausgestellt, daß derartige Impulse mittels des genannten Zeit/Spannungs-Wandlers für bestimmte Anwendungen noch nicht genau genug in Spannungswerte umgewandelt werden.

Es ist somit Aufgabe der vorliegenden Erfindung, eine genauere Umwandlung von Zeitwerten, die der Dauer eines Impulses entsprechen, in Spannungswerte zu ermöglichen.

Diese Aufgabe wird gelöst durch das Verfahren gemäß Anspruch 1 bzw. durch eine zur Durchführung des erfindungsgemäßen Verfahrens geeignete Vorrichtung gemäß dem ersten Sachanspruch.

Erfindungsgemäß wird der Spannungsverlauf eines Eingangsimpulses dem Verlauf einer Hilfsspannung mit rampenförmigem Verlauf, im folgenden kurz Rampenspannung genannt, insoweit angepaßt, daß der Abstand zwischen dem Impulsspannungs-Verlauf und dem Rampenspannungs-Verlauf innerhalb vorgegebener Werte liegt.

Weitere Vorteile der Erfindung sind zum einen, daß der elektrische Streß verwendeter Transistoren geringer ist. Zum anderen kann wegen einer kürzeren Abschaltzeit bei kleinen Datenspannungen das Ende der Rampe der Rampenspannung zeitlich näher zum Ende einer anzusteuernden Zeile verschoben werden. Daraus ergibt sich eine größere Genauigkeit.

Ausführungsbeispiele der Erfindung sind in der Zeichnung dargestellt und werden im Folgenden näher beschrieben. Es zeigen
- Fig. 1: eine bekannte Verstärkereinrichtung mit einem Spannungs/Zeit-Wandler und einem Zeit/Spannungs-Wandler,
- Fig. 2a,..,c Fig. 3: Spannungsverläufe bei einer Verstärkereinrichtung gemäß Figur 1,
- Fig. 4: ein erstes erfindungsgemäßes Ausführungsbeispiel,
- Fig. 5a,..,c Fig. 6: Spannungsverläufe bei dem Ausführungsbeispiel der Figur 4,
- Fig. 7: ein zweites erfindungsgemäßes Ausführungsbeispiel.

Bevor auf die Beschreibung der Ausführungsbeispiele näher eingegangen wird, sei darauf hingewiesen, daß die in den Figuren einzeln dargestellten Blöcke lediglich zum besseren Verständnis der Erfindung dienen. üblicherweise sind einzelne oder mehrere dieser Blöcke zu Einheiten zusammengefaßt. Diese können in integrierter oder Hypridtechnik oder als Programm gesteuerter Mikrorechner, bzw. als Teil eines zu seiner Steuerung geeigneten Programmes realisiert sein.

Weiterhin sei darauf hingewiesen, daß die in den einzelnen Stufen enthaltenen Elemente auch getrennt ausgeführt werden können.

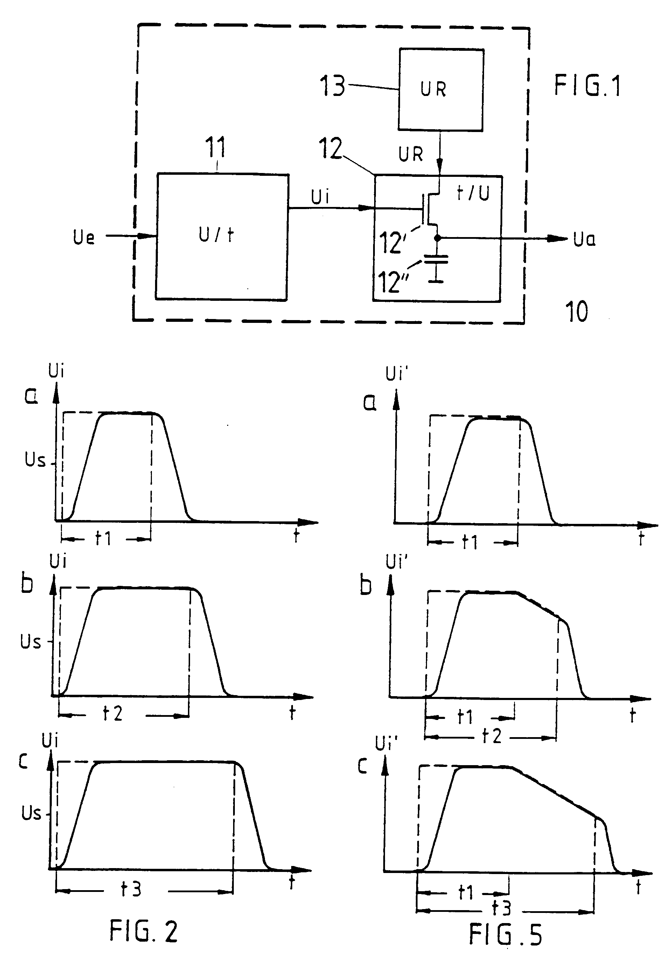

Figur 1 zeigt eine bekannte Verstärkungseinrichtung 10, die einen Spannungs/Zeit-Wandler 11 (U/t-Wandler) und einen Zeit/Spannungs-Wandler 12 (t/U-Wandler) enthält. Der Spannungs/Zeit-Wandler 11 bildet aus einem Eingangssignal Ue ein pulsbreitenmoduliertes Signal Ui, das er an einen ersten Eingang des Zeit/Spannungs-Wandlers 12 abgibt. Dieser ist über einen zweiten Eingang außerdem mit einem Rampenspannungsgenerator 13 verbunden, von dem er die Rampenspannung UR erhält. Aufgrund des Signales Ui und der Rampenspannung UR bildet der Zeit/Spannung-Wandler 12 ein Ausgangssignal Ua, das an seinem Ausgang zur Verfügung steht.

Der Zeit/Spannungs-Wandler 12 besteht beispielsweise aus einem MOS-Transistor 12', dessen Source-Anschluß die Rampenspannung UR zugeführt wird, und dessen Drain-Anschluß zu einem ersten Anschluß eines Kondensators 12" führt. Dem Gate-Anschluß von Transistor 12' wird das Signal Ui zugeführt und ein zweiter Anschluß des Kondensators 12" liegt auf Masse. An dem gemeinsamen Anschluß von dem Transistor 12' und dem Kondensator 12" kann das Ausgangssignal Ua entnommen werden.

Die Funktionsweise der Verstärkereinrichtung 10 gemäß Figur 1 ist in der genannten älteren Anmeldung beschrieben und auf sie soll im weiteren nur so weit eingegangen werden, wie es für das Verständnis der vorliegenden Erfindung notwendig ist.

Der Spannungs/Zeit-Wandler 11 erzeugt Impulse, wie sie in idealisierter Weise gestrichelt in Figur 2, bestehend aus den Figuren 2a, b, c, dargestellt sind. Diese Impulse weisen - in Abhängigkeit von dem Wandler 11 zugeführten unterschiedlichen Eingangsspannungen Ue - unterschiedliche zeitliche Längen t1, t2, bzw. t3 auf, und ihr Spannungswert ist über die gesamte Impulsdauer jeweils im wesentlichen konstant.

Mit durchgezogenen Linien sind in Figur 2 reale Impulsverläufe eingezeichnet, wie sie der Zeit/Spannungs-Wandler 12 von dem Spannungs/Zeit-Wandler 11 zugeleitet erhält. Diese Verläufe weichen gegenüber den idealisierten insofern ab, als daß ihre Flanken abgerundet sind, verursacht beispielsweise durch parasitäre Kapazitäten. Auf die Bedeutung eines in Fig. 2 eingezeichneten Schwellwertes Us wird weiter unten eingegangen.

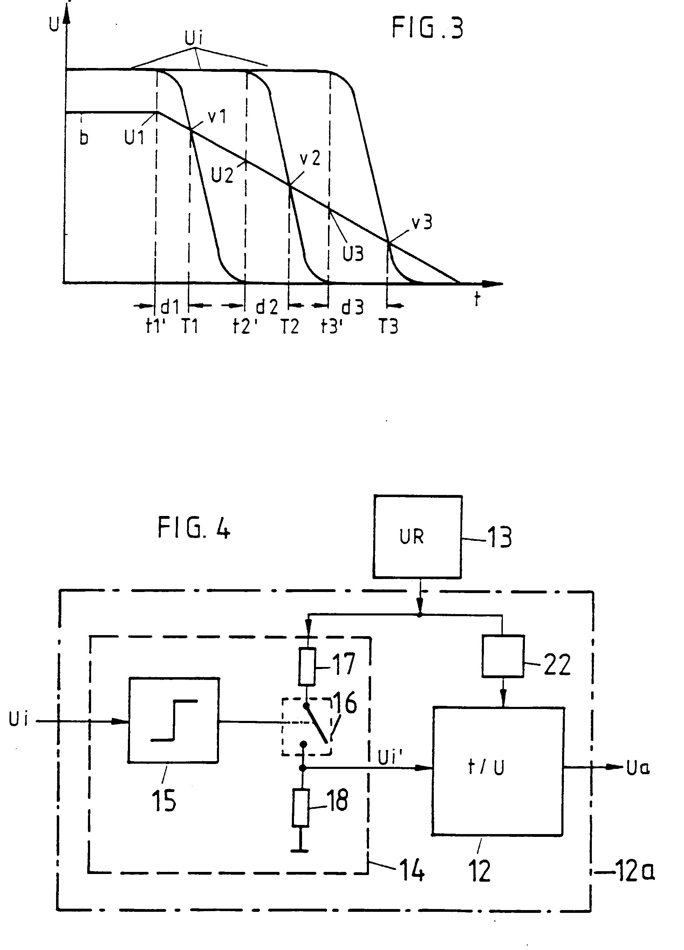

In Fig. 3 sind Kurven Ui dargestellt, die den rechten Flanken der realen Impulse der Fig. 2 entsprechen. Weiterhin ist in Fig. 3 eine Kurve b eingezeichnet, die im wesentlichen dem zeitlichen Verlauf der Rampenspannung UR entspricht, die in dieser bekannten Einrichtung beispielsweise erst nach Ablauf des Zeitraumes tl einen rampenförmigen Verlauf aufweist, was insbesondere dazu dient, daß der Kondensator 12b zunächst voll aufgeladen wird und die an ihm anliegende Spannung Ua anschließend hauptsächlich durch die Rampenspannung UR bestimmt wird.

Der Zeit/Spannungs-Wandler 12 gibt die Ausgangsspannung Ua mit einem Wert ab, der zu dem Zeitpunkt ermittelt wird, bei dem die Kurve Ui die Kurve b schneidet.

Es sei an dieser Stelle darauf hingewiesen, daß bei einer Realisierung des Zeit/Spannungs-Wandlers mittels Halbleiterbauelementen entsprechende Schwellspannungen zu berücksichtigen sind, die dann neben der Rampenspannung UR in der Kurve b enthalten sind.

Zum Zeitpunkt t1', zu dem der erste idealisierte Impuls aus Fig. 2a beendet ist, weist die Kurve b den Wert U1 auf. Durch die Abrundung überschneidet die Kurve des ersten realen Impulses die Kurve b jedoch erst zu einem Zeitpunkt T1 = t1'+ d1 bei einem Wert v1.

Zum Zeitpunkt t2, an dem der zweite idealisierte Impuls aus Fig. 2b beendet ist, weist die Kurve b den Wert U2 auf. Durch die Abrundung des zweiten Impulses überschneidet der Spannungswert des zweiten realen Impulses die Kurve b jedoch erst zu einem Zeitpunkt T2 = t2' + d2 bei einem Spannungswert v2, und analog überschneidet die abgerundete Flanke des dritten Impulses aus Fig. 2c die Kurve b erst zu einem Zeitpunkt T3 = t3' + d3 bei einem Spannungswert v3, anstelle eines Spannungswertes U3.

Die Differenzen v1 - U1, v2 - U2 und v3 - U3 sind nicht gleich groß, was bedingt ist durch unterschiedlich große Zeitdifferenzen d1, d2 und d3 bei gleichförmigem Flankenverlauf.

Das heißt, daß bei einer Zeit/Spannungs-Wandlung gemäß der Figuren 1 bis 3 Nichtlinearitäten auftreten.

Mit Hilfe der Figuren 4 bis 7 wird die vorliegende Erfindung anhand zweier Ausführungsbeispiele beschrieben. In den genannten Figuren sind Elemente sowie Spannungen, die die gleiche Funktion ausüben bzw. Wirkung angeben wie in den Figuren 1 bis 3, mit gleichen Bezugszeichen wie dort versehen. Auf sie soll im folgenden nur insofern eingegangen werden, wie es für das Verständnis der vorliegenden Erfindung wesentlich ist.

Figur 4 zeigt ein erstes Ausführungsbeispiel der erfindungsgemäßen Vorrichtung. Eine Vorrichtung zur Zeit/Spannungs-Wandlung 12a weist einen Impulsumformer 14 auf, der eine Schwellwertstufe 15 enthält, an dessen Eingang das Signal Ui anliegt und dessen Ausgang mit einem Steuereingang einer Schaltvorrichtung 16 verbunden ist. Ein erster Schaltanschluß dieser Schaltvorrichtung 16 ist mit einem ersten. Anschluß eines ersten Widerstandes 17 verbunden, dessen zweiter Anschluß mit dem Ausgang des Rampenspannungsgenerators 13 verbunden ist.

Ein zweiter Schaltanschluß der Schaltvorrichtung 16 ist zum einen mit dem ersten Anschluß eines zweiten Widerstandes 18, sowie mit dem ersten Eingang des Zeit/Spannungs-Wandlers 12 verbunden. Der zweite Anschluß des zweiten Widerstandes 18 liegt an Masse.

Dem Zeit/Spannungs-Wandler 12 wird die Rampenspannung UR über ein Reduzierglied 22 zugeführt, das die Rampenspannung UR additiv, beispielsweise durch Subtraktion einer Spannung, und/oder multiplikativ, beispielsweise durch ein geeignetes Dämpfungsglied (Verstärkungsfaktor kleiner 1), reduziert und diese reduzierte Spannung an den zweiten Eingang des Zeit/Spannungs-Wandlers 12 weiterleitet.

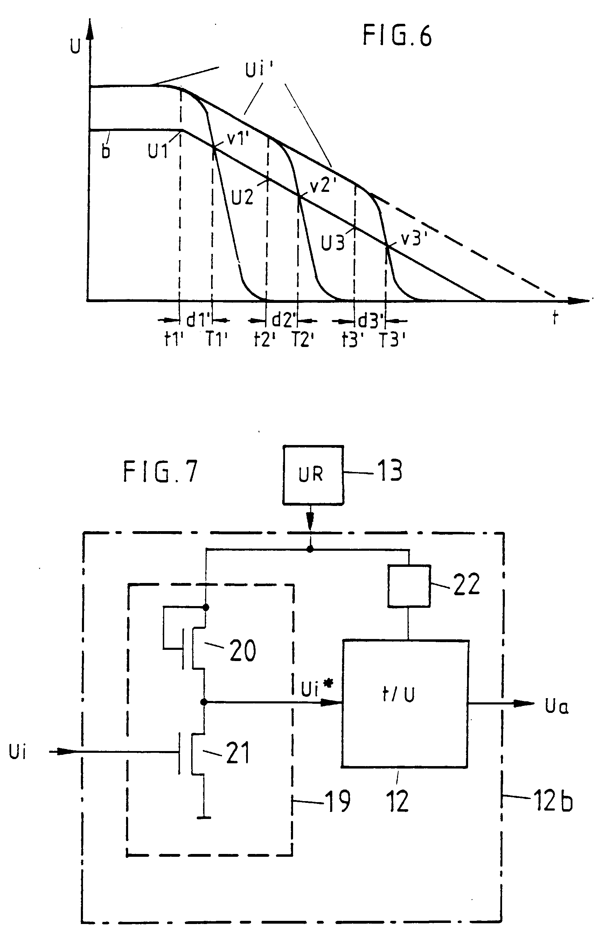

Die Funktion der erfindungsgemäßen Vorrichtung gemäß Fig. 4 wird nun mit Hilfe von Fig. 2, bestehend aus den Figuren 2a, b, c, und Fig. 5, bestehend aus den Figuren 5a, b, c, erläutert.

Das Signal Ui, das reale Impulse gemäß Fig. 2 aufweist, wird der Schwellwertstufe 15 zugeführt, die bei überschreiten des vorgegeben Schwellwertes Us die Schaltvorrichtung 16 betätigt, so daß die Verbindung zwischen dem ersten Widerstand 17 und dem zweiten Widerstand 18 hergestellt ist. Bei Unterschreiten des genannten Schwellwertes Us wird die Schaltvorrichtung 16 wieder geöffnet. Ein entsprechendes Ansteuersignal für die Schaltvorrichtung 16 entspricht in seinem zeitlichen Verlauf im wesentlichen den idealisierten Impulsen der Fig. 2. Die Lage des Schwellwertes Us wird bevorzugt in Abhängigkeit der Abrundung des realen Impulses Ui (Fig. 2) derart bestimmt, daß die Zeit, in der die Schaltvorrichtung 16 jeweils geschlossen ist, der Dauer der idealen Impulse Ui (Fig. 2) entspricht.

Bei geschlossenem Kontakt der Schaltvorrichtung 16 bilden die beiden Widerstände 17, 18 einen Spannungsteiler. Reale Impulse, d. h. Impulse mit abgerundeten Flanken, eines an den Zeit/Spannungs-Wandler 12 abgegebenen Signales Ui' sind in Fig. 5 mit durchgezogenen Linien gezeichnet. Wesentlich ist, daß der Spannungsverlauf der Impulse während der jeweiligen Impulsdauer nicht konstant ist, sondern durch die Rampenspannung UR beeinflußt wird.

Wird von einem Verlauf der Rampenspannung gemäß Kurve b von Fig. 3 ausgegangen, d.h. der rampenförmig abfallende Verlauf setzt erst ab dem Zeitpunkt t1' ein, so behält der erste Impuls Ui (Fig. 2a), der eine Dauer t1 aufweist, bei seiner Weiterleitung zum ersten Eingang des Zeit/Spannungs-Wandlers 12, seinen Verlauf insofern bei, als daß sein Spannungsverlauf Ui (Fig. 5a) während seiner gesamten Dauer im wesentlichen konstant ist.

Der zweite Impuls Ui (Fig. 2b) mit der Dauer t2 hingegen, weist an dem genannten Eingang einen geänderten Spannungsverlauf Ui' (Fig. 5b) derart auf, daß sein ursprünglich konstanter Spannungsverlauf nach Ablauf der Zeitdauer t1 linear abfällt. Einen vergleichbaren Verlauf weist ebenfalls der dritte Impuls auf.

Die genannten am ersten Eingang des Zeit/Spannungs-Wandlers 12 anliegenden Impulse sind ebenfalls in der Figur 6 eingetragen, in der zusätzlich die Kurve b eingezeichnet ist.

Durch das Reduzierglied 22 wird der Abstand der Kurven Ui' und der Kurve b vorgegeben. Wesentlich ist, daß der Verlauf der Spannungen Ui' bei Anliegen eines Impulses Ui, d.h. in diesem Ausführungsbeispiel bei geschlossener Schaltvorrichtung 16, oberhalb der Kurve b liegt.

Durch den umgeformten Verlauf der Impulse ergibt sich, daß der erste Impuls die Kurve b zu einem Zeitpunkt T1' = t1'+ d1' bei einem Spannungswert v1', der zweite Impuls die Kurve b zu einem Zeitpunkt T2' = t2' + d2' bei einem Spannungswert v2' und der dritte Impuls die Kurve b zu einem Zeitpunkt T3' = t3' + d3' bei einem Spannungswert v3' schneidet.

Wird von gleichartigen Abrundungen der rechten Flanken der Impulse ausgegangen, so sind die Zeitdifferenzen dl', d2', d3' durch den im wesentlichnen parallelen Verlauf der Einhüllenden der der Kurven Ui und und der Kurve b gleich groß. Das bewirkt bei einem gleichförmigen Rampenverlauf, daß die Spannungsdifferenzen v1' - U1, v2' - U2 und v3' - U3 konstant sind. Dadurch werden Ungenauigkeiten bei der Zeit/Spannungs-Wandlung vermieden.

Bei einer Anwendung der erfindungsgemäßen Vorrichtung 12a zur Zeit/Spannungs-Wandlung als Teil der Verstärkereinrichtung 10 wird dadurch eine im wesentlichen lineare Verstärkung ermöglicht.

Falls es erforderlich ist, das Signal des Spannungs/Zeit-Wandlers 11 zu invertieren, bevor es dem Zeit/Spannungs-Wandler 12 zugeführt wird, so kann das zweite Ausführungsbeispiel gemäß Fig. 7 verwendet werden.

Die invertierende Vorrichtung 12b zur Zeit/Spannungs-Wandlung enthält anstelle der Impulswandlerstufe 14 einen Inverter 19, wie er beispielsweise in Figur 7 dargestellt ist.

Dieser Inverter 19 weist einen ersten MOS-Transistor 20 und einen zweiten MOS-Transistor 21 auf. Der Source-Anschluß des ersten Transistors 20 ist mit dessen Gate-Anschluß sowie mit dem Rampenspannungsgenerator 13 verbunden. Der Drain-Anschluß des ersten Transistors 20 ist mit dem Source-Anschluß des zweiten Transistors 21 verbunden. An dem Gate-Anschluß des zweiten Transistors 21 liegt das pulsbreitenmodulierte Signal Ui an und der Drain-Anschluß des zweiten Transistors 21 liegt auf Masse. An dem gemeinsamen Anschluß der beiden Transistoren 20, 21 kann eine Spannung Ui* abgegriffen werden, die eine Inversion des Signales Ui, gewichtet mit dem Spannungsverlauf der Rampenspannung UR, darstellt.

Es sei an dieser Stelle darauf hingewiesen, daß wegen des symmetrischen Aufbaus von MOS-Transistoren jeweils die Bezeichnungen Source- und Drain-Anschluß vertauschbar sind.

Bei einer anderen, nicht dargestellten, Variante der Erfindung ist die Ausgangsspannung nicht von dem rampenförmigen Verlauf der Rampenspannung UR abhängig, sondern von einer an einem Kondensator anliegenden Spannung, der mit einer Quelle verbunden ist, die ihm einen Strom vorgegebener Werte einprägt und/oder ihm eine Spannung vorgegebener Werte zuführt.

In diesem Fall ist die Spannung der Impulse der Signale Ui' bzw. Ui* entsprechend anzupassen.

Versionen der genannten Ausführungsbeispiele können zumindest eine der folgenden Variationen aufweisen:
- statt des Reduziergliedes 22 oder zusätzlich zu diesem kann zwischen dem Rampenspannungsgenerator 13 und dem Impulsumformer 14 bzw. dem Inverter 19 ein Mittel vorgesehen sein, das die Rampenspannung UR additiv, beispielsweise durch Addition einer Spannung, und/oder multiplikativ, beispielsweise durch Verstärkung, erhöht und diese erhöhte Spannung an den Impulsumformer 14 bzw. den Inverter 19 weiterleitet;
- der Verlauf der von dem Impulsumformer 14 bzw. dem Inverter 19 abgegebenen Impulse kann derart sein, daß die Impulsspannungen nicht parallel zu einer Hilfsspannung, die der Rampenspannung UR oder einer an Bauelementen anliegenden Spannung entspricht, verlaufen, sondern daß sich ihr Abstand in vorgegebenen Grenzen ändert. Das entspricht einer additiven und/oder multiplikativen Verknüpfung der Spannungswerte der Impulse mit Funktionswerten der zeitlichen Funktion der Hilfsspannung und kann beispielsweise erreicht werden durch zusätzliche Bauelemente, wie Dioden oder sonstige Halbleiterbauelemente, die einzeln oder als Kombination parallel und/oder in Reihe mit den gezeigten Bauelementen geschaltet sein können. Dadurch können beispielsweise Unlinearitäten, die irgendwo in einem System, zu dem der Zeit/Spannungs-Wandler gehört, vermindert oder vermieden werden.

Somit wird erfindungsgemäß ein System, bestehend aus einem Verfahren und einer bevorzugten zur Durchführung des erfindungsgemäßen Verfahrens geeigneten Vorrichtung, vorgestellt, das Spannungswerte bestimmt, die der Dauer von Impulsen entsprechen.

Um Nichtlinearitäten bei der Umwandlung zu vermeiden, werden Spannungen der Impulse, deren Dauer zur Zeit/Spannung-Umwandlung dienen, dem Verlauf einer Hilfsspannung angeglichen, die zur Bildung der Ausgangsspannung dient. Diese Hilfsspannung kann eine von einem Rampenspannungsgenerator abgegebene Rampenspannung oder eine sonstige Spannung sein, die an Bauelementen der erfindungsgemäßen Vorrichtung anliegt.

Durch die Erfindung können Nichtlinearitäten bei der Zeit/Spannungs-Umwandlung vermindert oder vermieden werden.

Bei einer Anwendung als Teil eines Gesamtsystems, beispielsweise einer Verstärkereinrichtung, können somit entsprechende Nichtlinearitäten zumindest vermindert oder kompensiert werden.

Das erfindungsgemäße System kann bevorzugt als Teil einer Verstärkervorrichtung benutzt werden, die in Dünnschichttechnik ausgeführt ist und zur Ansteuerung einer Flüssigkristall-Anzeige dient.

## Patentansprüche

1. Verfahren zur Umwandlung eines Zeitwertes, der der Dauer eines Impulses mit vorgebbarem Spannungsverlauf entspricht, in einen Spannungswert wobei die Feststellung des Zeitpunktes der hinteren Flanke durch Spannungsvergleich mit einer zeitveränderlichen Hilfsspannung erfolgt und die Hilfsspannung eine Steigung bei einem Rampenabschnitt aufweist und der Impuls vor der Umwandlung entsprechend den Werten der Hilfsspannung umgeformt wird.

2. Verfahren nach Anspruch 1, dadurch gekennzeichnet, daß der Spannungsverlauf des umgeformten Impulses im wesentlichen der zeitlichen Funktion der Hilfsspannung folgt.

3. Verfahren nach einem der Ansprüche 1 oder 2, dadurch gekennzeichnet, daß die zeitveränderliche Hilfsspannung zumindest zeitweise einer zeitlich linear zunehmenden oder abnehmenden Funktion folgt.

4. Verfahren nach einem der Ansprüche 1 bis 3, dadurch gekennzeichnet, daß Werte des Spannungsverlaufs des Impulses einer additiven und/oder multiplikativen Verknüpfung mit Funktionswerten der zeitveränderlichen Hilfsspannung entsprechen.

5. Vorrichtung zur Umwandlung eines Zeitwertes, der der Dauer eines Impulses mit vorgebbarem Spannungsverlauf entspricht, in einen Spannungswert (Ua) mit
- einem Hilfsspannungsgenerator (13), der eine zeitveränderliche Hilfsspannung (UR) erzeugt, wodurch die Feststellung des Zeitpunktes der hinteren Flanke des Impulses erfolgt, wobei die Hilfsspannung eine Steigung bei einem Rampenabschnitt aufweist,
- einem Zeit/Spannungs-Wandler (12a), der einen Spannungsvergleich des Impulses (Ui) mit vorgebbarem Spannungsverlauf mit der Zeitveränderlichen Hilfsspannung bewirkt,
- mit Mitteln (14; 19), die den Impuls (Ui) vor der Umwandlung entsprechend den Werten der Hilfsspannung umformen.

6. Vorrichtung gemäß Anspruch 5, dadurch gekennzeichnet, daß die Mittel (14, 19) derart ausgebildet sind, daß der Spannungsverlauf des umgeformten Impulses der zeitveränderlichen Hilfsspannung im wesentlichen folgt.

7. Vorrichtung nach einem der Ansprüche 5 oder 6, dadurch gekennzeichnet, daß die zeitveränderliche Hilfsspannung zumindest zeitweise einer zeitlich linear zunehmenden oder abnehmenden Funktion folgt.

8. Vorrichtung nach einem der Ansprüche 5 bis 7, dadurch gekennzeichnet, daß Mittel (22, 14; 19) vorgesehen sind, die Werte des Spannungsverlaufs des Impulses mit Funktionswerten der zeitveränderlichen Hilfsspannung (UR) additiv und/oder multiplikativ verknüpfen.

## Claims

1. Method of converting a time value which corresponds to the duration of a pulse having a predeterminable voltage waveform into a voltage value, wherein the determination of the time point of the trailing edge is effected by means of a voltage comparison with a time varying auxiliary voltage and the auxiliary voltage having a slope over a ramp section and the pulse being shaped before the conversion process in correspondence with the values of the auxiliary voltage.

2. Method in accordance with Claim 1, **characterised in that**, the voltage waveform of the shaped pulse substantially follows the function with respect to time of the auxiliary voltage.

3. Method in accordance with either of Claims 1 or 2, **characterised in that**, the time varying auxiliary voltage follows a linearly increasing or decreasing function with respect to time, at least some of the time.

4. Method in accordance with any of the Claims 1 to 3, **characterised in that**, the values of the voltage waveform of the pulse correspond to a logical process of addition or multiplication with functional values of the time varying auxiliary voltage.

5. Apparatus for converting a time value which corresponds to the duration of a pulse having a predeterminable voltage waveform into a voltage value (Ua), including
- an auxiliary voltage generator (13) which generates a time varying auxiliary voltage (UR) by means of which the determination of the time point of the trailing edge of the pulse is effected, wherein the auxiliary voltage has a slope over a ramp section,
- a time/voltage converter (12a) which effects a voltage comparison of the pulse (Ui) having a predeterminable voltage waveform with the time varying auxiliary voltage,
- and including means (14; 19) which shape the pulse (Ui) before the conversion process in correspondence with the values of the auxiliary voltage.

6. Apparatus in accordance with Claim 5, **characterised in that**, the means (14; 19) are constructed in such a way that the voltage waveform of the shaped pulse substantially follows the time varying auxiliary voltage.

7. Apparatus in accordance with either of Claims 5 or 6, **characterised in that**, the time varying auxiliary voltage follows a linearly increasing or decreasing function with respect to time, at least some of the time.

8. Apparatus in accordance with any of the Claims 5 to 7, **characterised in that**, there are provided means (22, 14; 19) which logically combine in an additive or multiplicative manner the values of the voltage waveform of the pulse with functional values of the time varying auxiliary voltage (UR).

## Revendications

1. Procédé de conversion d'une valeur de temps correspondant à la durée d'une impulsion à caractéristique de tension prédéfinissable, en une valeur de tension, où : la constatation du moment du flanc arrière se fait par comparaison de tension avec une tension auxiliaire variant dans le temps ; la tension auxiliaire décrit une pente sur une section en rampe ; l'impulsion est transformée avant la conversion, selon les valeurs de la tension auxiliaire.

2. Procédé d'après la revendication 1, caractérisé en ce que, la caractéristique de tension de l'impulsion transformée suit pour l'essentiel la fonction temporelle de la tension auxiliaire.

3. Procédé d'après une des revendications 1 ou 2, caractérisé en ce que, la tension auxiliaire variant dans le temps suit au moins périodiquement une fonction croissante ou décroissante linéairement dans le temps.

4. Procédé d'après une des revendications 1 à 3, caractérisé en ce que, les valeurs de la caractéristique de tension de l'impulsion correspondent à une liaison additive et/ou multiplicative avec les valeurs de la fonction de la tension auxiliaire variant dans le temps.

5. Dispositif de conversion d'une valeur de temps, correspondant à la durée d'une impulsion à caractéristique de tension prédéfinissable, en une valeur de tension (Ua) avec
- un générateur de tension auxiliaire (13), qui génère une tension auxiliaire (UR) variant dans le temps, ce qui entraîne la constatation du moment du flanc arrière de l'impulsion, la tension auxiliaire décrivant une pente sur une section en rampe,
- un convertisseur temps/tension (12a), qui produit une comparaison de tension de l'impulsion (Ui) à caractéristique de tension prédéfinissable avec la tension auxiliaire variant dans le temps,
- des moyens (14, 19), qui transforment l'impulsion (Ui) avant la conversion selon les valeurs de la tension auxiliaire.

6. Dispositif conformément à la revendication 5, caractérisé en ce que, les moyens (14, 19) sont formés de telle façon que la caractéristique de tension de l'impulsion transformée suit pour l'essentiel la tension auxiliaire variant dans le temps.

7. Dispositif d'après une des revendications 5 ou 6, caractérisé en ce que, la tension auxiliaire variant dans le temps suit au moins périodiquement une fonction croissante ou décroissante linéairement dans le temps.

8. Dispositif d'après une des revendications 5 à 7, caractérisé en ce que, des moyens (22,14, 19) sont prévus pour lier de manière additive et/ou multiplicative les valeurs de la caractéristique de tension de l'impulsion avec les valeurs de la fonction de la tension auxiliaire (UR) variant dans le temps.
